# EUROPEAN PATENT APPLICATION

(11) **EP 0 568 363 A2**
(43) Date of publication of application: **03.11.1993**
(21) Application number: 93303352.4
(22) Date of filing: 28.04.1993
(51) Int. Cl.: H01L 21/311, H01L 21/00, C23F 1/00

(54) **Process for etching films in a sealed photochemical reactor**

(30) Priority: 30.04.1992 US 876043
(71) Applicant: SUBMICRON SYSTEMS, INC., Allentown, PA 18106 (US)
(72) Inventor: Grant, Robert W., Excelsior, Minnesota 55331 (US); Torek, Kevin, State College, PA 16801 (US); Novak, Richard E., Plymouth, Minnesota 55447 (US); Ruzyllo, Jerzy, State College, PA 16801 (US)
(74) Representative: Parr, Ronald Edward R.E. Parr & Co.

(57) **Abstract**

A process for etching oxide films on the semiconductor, or other substrates, in a sealed photochemical reactor. Anhydrous hydrogen fluoride (AHF) gas, or other halogen containing gases, and alcohol vapor carried by an inert gas, such as nitrogen, are passed over the oxides to be etched. The UV radiation shines through a window, which passes the UV radiation onto the oxides while the gases are flowing, and enhances and controls etching of the oxides. The UV window is impervious to the etch process gases. The etch rates are modified, providing for improved oxide etching characteristics.

## Description

This invention relates to a process of etching a surface film, coating or other layer carried by a semiconductor or other substrate.

In particular, though not exclusively, it relates to a process of etching an oxide film or other layer on a semiconductor or other substrate, for example in "front- end-semiconductor processing".

In front-end processing of semiconductors it has been a problem during etching to remove oxide at an appropriate rate but without etching excessive amounts of any other films carried by the semiconductor substrate, without the need to add moisture to the etching gas stream at the same time. Such oxides are borophosphate silicate glass, spun on glass, sputtered, chemical vapor deposited, thermal, or native/chemically grown (incidental). It has been a problem to etch a desired thickness of these oxides at about room temperature and atmospheric pressure without attacking other materials which are required to remain on the substrate. The prior art processes have used for etching hydrogen fluoride (HF) gas, HF gas plus water vapor or HF gas and methanol.

The present invention provides a process which overcomes the problems referred to above. Accordingly, the present invention provides a process of etching a surface layer carried by a semiconductor or other substrate,
characterised in that it comprises contacting the substrate with a halogen-containing gas (or a hydrogen-containing gas) and an alcohol, while being subjected to ultraviolet radiation.

An important advantage of the present invention over prior art processes is that it does not require the use of water vapor, thereby avoiding the problem of corrosion associated with those prior art processes yet without compromising etch characteristics. Thus, in a preferred form of the invention the process is carried out under anhydrous conditions. However, water vapor can be used if desired.

The term "halogen-containing gas" as used herein includes a gas that consists of, or contains, a halogen or halogens selected from fluorine, chlorine, bromine and iodine, or a gas that consists of, or contains, a compound containing one or more halogens. The invention is concerned particularly, though not exclusively, with gases that consist of, or contain , fluorine or a compound containing fluorine; examples of such compounds are hydrogen fluoride (HF), hydrogen chloride (HC1) nitrogen trifluoride (NF₃ ) and monochloro trifluoro methane (CC1F₃ ). The "halogen-containing gas" is preferably used in an anhydrous state.

The "alcohol" used in the present invention can be, for example, an alkanol or other suitable aliphatic alcohol. Suitable alkanols are mono-hydroxy alkanols for examples methanol, ethanol, propanol, iso-propanol or other C₁₋₄ alkanols.

The ultraviolet radiation used in the process of the invention conveniently has a wavelength in the range from 150 to 600 nanometers.

In preferred forms the present invention uses ultraviolet stimulation in the wavelength range of 150-600 nanometers for the etching oxide films carried by a semiconductor or other substrate in front-end fabrication, using gaseous anhydrous hydrogen fluoride (AHF), and methanol vapor. The purpose of the ultraviolet radiation is to enhance and control the rate of etch of the oxide layer.

Further preferred features of the process of the invention are:
(a) etching oxide films on semiconductor substrates to control oxide etch rates, while eliminating or at least minimizing use of water vapor, and hence, corrosion; and
(b) obtaining etch rates that are far and above those etch rates previously obtained using prior art etch processes.

The process of the present invention can be used, for example, for etching oxide films on a semiconductor substrate in a dry cluster tool such as that disclosed in a U.S. patent application entitled "Cluster Tool Dry Cleaning System" by Robert Grant et al., U.S. Serial No. 07/820 985, filed January 15, 1992, and European Patent Application 93 300 200.8, filed 13 January 1993 which claims priority from said U.S. patent Application 07/820 985, both of which are incorporated herein by reference.

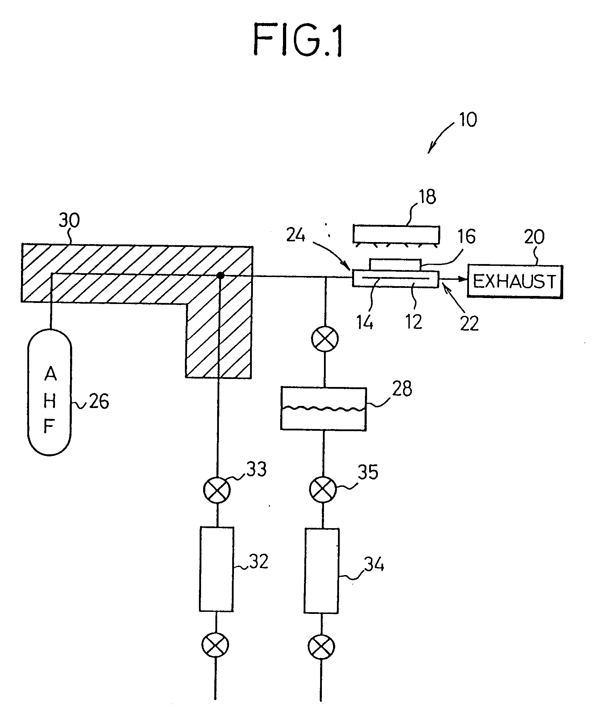

There is now described, by way of example and with reference to the accompanying drawing , a preferred embodiment of the process of the present invention. The drawing (Figure 1 only) illustrates a schematic diagram of apparatus for use in the process for etching of an oxide film on a semiconductor substrate.

FIG. 1 illustrates a schematic view of an apparatus (10) for performing the process for etching at least one oxide film from a semiconductor or other substrate. A chamber (12) is of sufficient size to accommodate the substrate (14). A UV window (16) passes ultraviolet radiation in a range of 150-600 nanometers radiated, for example, by an ultraviolet generator lamp (18). Connected to the outlet end (22) of the chamber (12) is an exhaust port (20). At an inlet end (24), are sources of gaseous anhydrous hydrogen fluoride (AHF) from a cylinder (26) and methanol vapor from a methanol bubbler (28). AN optional heater (30) can heat the cylinder (26) to increase the cylinder pressure of the AHF liquefied gas and/or to prevent the AHF gas from condensing as it expands through orifices in the gas delivery system following actuation of valve (33). An optional nitrogen source (34) carries the methanol vapor through the bubbler (28) following actuation of valve (35).

### MODE OF OPERATION

The substrate (14) carrying the oxide film is placed in a sealed photochemical reactor (12) used in a "stand-alone" unit or as a part of a dry cluster tool (for example that disclosed in the European Patent Application 93 300 200.8 referred to above).

The etching of the oxide film or films on the substrate by the gaseous anhydrous hydrogen fluoride (AHF) is controlled by the methanol vapor, the AHF and methanol being subjected to the ultraviolet radiation in the wavelength range of 150-600 nanometers. The ultraviolet radiation enhances and controls the etch rates of the oxide or oxides while also substantially eliminating or obviating the need for water vapor in the process gases, thereby minimizing or negating corrosion.

## Claims

1. A process of etching a surface layer carried by a semiconductor or other substrate,
characterised in that it comprises contacting the substrate with a halogen-containing gas and an alcohol, while being subjected to ultraviolet radiation.

2. A process according to Claim 1, wherein the substrate is contacted concurrently with the halogen-containing gas and the alcohol.

3. A process according to Claim 1, wherein the substrate is contacted sequentially with the halogen-containing gas and the alcohol.

4. A process according to Claim 1, 2 or 3, wherein the process is carried out under anhydrous conditions.

5. A process according to any of the preceding claims, wherein the halogen-containing gas is anhydrous hydrogen fluoride.

6. A process according to any of the preceding claims, wherein the alcohol is methanol.

7. A process according to Claim 1, wherein the ultraviolet radiation is in the wavelength range from 150 to 600 nanometers.

8. A process for etching at least one oxide film on the semiconductor or other substrate comprising the steps of:
(a) placing a substrate in a stand-alone chamber or chamber connected to a cluster tool;
(b) simultaneously or sequentially passing gaseous anhydrous hydrogen fluoride, or other halogen containing gases, and alcohol vapor through said chamber; and
(c) illuminating the interior of said chamber with ultraviolet radiation.

9. A process according to any of the preceding claims, wherein the substrate is enclosed in a treatment chamber (12) having in a wall thereof a window (16) to permit the transmission of ultraviolet radiation from a source (18) thereof outside the chamber; and
means are provided to feed halogen-containing gas and alcohol vapor through the chamber.
